(19) Europäisches Patentamt / European Patent Office / Office européen des brevets

(11) **EP 4 668 578 A1**

(12) **EUROPEAN PATENT APPLICATION**

(43) Date of publication:
24.12.2025 Bulletin 2025/52

(21) Application number: 25181407.5

(22) Date of filing: **06.06.2025**

(51) International Patent Classification (IPC):
*H03F 1/32* (2006.01)        *H03F 3/195* (2006.01)
*H03F 3/24* (2006.01)        *H04B 1/04* (2006.01)
*G06N 3/00* (2023.01)

(52) Cooperative Patent Classification (CPC):
H03F 1/3247; G06N 3/00; G06N 3/04; G06N 3/045;
G06N 3/048; G06N 3/063; G06N 3/08; G06N 3/082;
G06N 3/084; H03F 1/3252; H03F 1/3258;
H03F 3/195; H03F 3/245; H04B 1/0475;
H03F 2200/451;                    (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.06.2024 US 202463661446 P**

(71) Applicant: **Analog Devices International
Unlimited Company
Limerick (IE)**

(72) Inventors:
• CHANDRASEKARAN, Praveen
  Co. Limerick (IE)
• RASLAN, Ahmed Mohamed Ragaei Abdelhamid
  Co. Limerick (IE)
• CHUANG, Kevin
  Wilmington, 01887 (US)
• MUNDHADA, Kaustubh Pradeepkumar
  Co. Limerick (IE)

(74) Representative: **Yang, Shu
Withers & Rogers LLP
2 London Bridge
London SE1 9RA (GB)**

(54) **NEURAL VOLTERRA SYSTEM FOR DIGITAL PREDISTORTION**

(57)    Aspects of this disclosure relate to Neural Volterra actuators. **In** an embodiment, a Neural Volterra actuator includes a first processing block that includes an artificial neural network, a second processing block that includes non-linear gain blocks, multipliers, a connection circuit configured to adjust an electrical connection to an input of a multiplier of the multipliers, and a combiner that generates a combined output signal based on output signals from the multipliers. The combined output signal can be a digitally predistorted version of an input signal received by the Neural Volterra actuator. Related methods and systems are also disclosed.

EP 4 668 578 A1

(52) Cooperative Patent Classification (CPC): (Cont.)
H03F 2201/3224; H03F 2201/3233

**Description**

CROSS REFERENCE TO PRIORITY APPLICATION

Any and all applications for which a foreign or domestic priority claim is identified in the Application Data Sheet as filed with the present application are hereby incorporated by reference under 37 C.F.R. § 1.57. This application claims the benefit of priority of U.S. Provisional Application No. 63/661,446, filed June 18, 2024 and titled "NEURAL VOLTERRA SYSTEM FOR WIRELESS COMMUNICATION SYSTEMS," the disclosure of which is hereby incorporated by reference in its entirety and for all purposes.

BACKGROUND

TECHNICAL FIELD

The present disclosure generally relates to digital compensation. Aspects of this disclosure can be implemented in a digital predistortion (DPD) system in a transceiver product.

DESCRIPTION OF RELATED TECHNOLOGY

Transceivers may be used by wireless devices to transmit and/or receive radio frequency signals. Components of a transceiver, such as a radio frequency power amplifier, can have non-linearities. DPD is a technique that can distort a digital signal in an input signal chain for a non-linear component to compensate for a non-linearity. DPD can be implemented in high performance transceivers. As wireless system specifications become more demanding, higher performance and/or more efficient DPD is desired.

SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a Neural Volterra actuator. The Neural Volterra actuator includes a first processing block comprising an artificial neural network, a second processing block comprising a non-linear gain blocks, multipliers configured to receive output signals of the second processing block, a connection circuit having an input connected to an output of the artificial neural network, and a combiner configured to generate a combined output signal based on output signals from the multipliers and to output the combined output signal. The multipliers include a first multiplier and a second multiplier. The connection circuit is configured to adjust an electrical connection to an input of the first multiplier. The combined output signal is a digitally predistorted version of an input signal received by the Neural Volterra actuator.

The connection circuit can include a fixed connection between a second output of the artificial neural network and the second multiplier. The connection circuit can electrically connect an input of the second multiplier to either a second output of the artificial neural network or an output of a delay line. The connection circuit can electrically connect an input to the second multiplier to either a second output of the artificial neural network or an output of a signal partitioning block. The connection circuit can electrically connect the input of the first multiplier to the output of the artificial neural network in a first state and to electrically connect the input of the first multiplier to an output of a delay line in a second state.

The artificial neural network can include neurons and programmable connections between the neurons. The neurons can include roaming neurons. A neuron of the neurons can include a look up table and feedback path from a scaled output of the look up table.

The artificial neural network can include programmable connections between neurons in different layers of the artificial neural network. The artificial neural network can receive a signal from a sensor.

The first processing block can include a plurality of non-linear preprocessing blocks having outputs connected to inputs of the artificial neural network.

The second processing block can include non-linear preprocessing blocks having outputs connected to inputs of the non-linear gain blocks. The Neural Volterra actuator can further include a second connection circuit configured to adjust electrical connections to the non-linear preprocessing blocks. The non-linear gain blocks can include look up tables.

Another aspect of this disclosure is a method of configuring a Neural Volterra actuator for digital predistortion. The method includes electrically connecting an output of an artificial neural network to an input of a multiplier with a connection circuit such that the multiplier is configured to multiply an output signal from the artificial neural network with a signal from a second processing path that includes a non-linear gain block. The Neural Volterra actuator includes the artificial neural network, the connection circuit, a plurality of multipliers comprising the multiplier, a plurality of non-linear gain blocks comprising the non-linear gain block, and a combiner configured to generate a combined output signal based on output signals from the plurality of multipliers. The combined output signal is a digitally predistorted version of an input signal received by the Neural Volterra actuator.

The method can include adjusting an electrical connection to the input of the multiplier with the connection circuit such that an output of a signal partitioning block is provided to the input of the multiplier.

The method can include adjusting connections between neurons of the artificial neural network in different layers of the artificial neural network.

The connection circuit can provide a fixed connection between a second output of the artificial neural network and an input of a second multiplier of the plurality of multipliers.

The second processing path can include a non-linear preprocessing block having an output connected to an input of the non-linear gain block. The method can further include setting a connection to an input of the non-linear preprocessing block with a second connection circuit.

Another aspect of this disclosure is a system with digital predistortion. The system includes a transceiver integrated circuit and a power amplifier in communication with the transceiver integrated circuit. The transceiver integrated circuit includes a digital predistortion system. The digital predistortion system includes a Neural Volterra actuator. The Neural Volterra actuator includes a first processing block comprising an artificial neural network; a second processing block comprising a non-linear gain blocks; multipliers configured to receive output signals of the second processing block, the multipliers comprising a first multiplier and a second multiplier; a connection circuit having an input connected to an output of the artificial neural network, the connection circuit configured to adjust an electrical connection to an input of the first multiplier; and a combiner configured to generate a combined output signal based on output signals from the multipliers and to output the combined output signal. The combined output signal is a digitally predistorted version of an input signal received by the Neural Volterra actuator. The digital predistortion system is configured to reduce a non-linearity of the power amplifier.

The system can further include an antenna in communication with the power amplifier.

The system can further include a sensor, and the artificial neural network can receive a sensor signal from the sensor.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

BRIEF DESCRIPTION OF THE DRAWINGS

Embodiments of this disclosure will be described, by way of non-limiting example, with reference to the accompanying drawings.

Figure 1 is a schematic diagram of a wireless system that can implement embodiments of this disclosure.
Figure 2 is a schematic block diagram of a Neural Volterra system according to an embodiment.
Figure 3 is a flow diagram of a method of Neural Volterra design according to an embodiment.
Figure 4 is a schematic block diagram of a Neural Volterra system according to an embodiment.
Figure 5 is a schematic diagram of a Neural Volterra actuator according to an embodiment.
Figure 6 includes a schematic diagram of a neural processing element according to an embodiment.
Figure 7 is a schematic diagram of an embodiment of the neural processing element of Figure 6.
Figure 8 is a schematic diagram of components of a neural actuator according to an embodiment.
Figure 9 is a schematic diagram of a reconfigurable neural actuator according to an embodiment.
Figure 10 is a schematic block diagram for a non-linear pre-processing block according to an embodiment.
Figure 11 is a schematic block diagram for a linear look up table interpolation block.
Figure 12 is a schematic diagram of a Neural Volterra actuator according to an embodiment.
Figure 13 is a schematic block diagram of a communication system that includes digital predistortion according to an embodiment.

DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings.

High-performance system-on-chip (SoC) transceiver-based wireless solutions can include digital predistortion (DPD). DPD can elevate the radio frequency performance (e.g., bandwidth and emission) of the radio system. Certain DPD solutions operating at an in-phase/quadrature (IQ) sample rate are based on the complex baseband Volterra series. Multistage Volterra based models have shown high performance for linearizing single-input single-output (SISO) power amplifiers in harsh test conditions. Volterra based models have a complexity of optimizing coefficients that scales quadratically with respect to the number of features. Thus, power consumption and implementation area can be highly dependent on model choice. Other DPD solutions relate to artificial neural networks (ANNs). ANNs with pruning techniques have shown desirable results to compensate for non-linearities for wide bandwidth multiple-input signal-output (MISO) power amplifiers, such as load modulated balanced amplifiers (LMBAs).

The existing DPD approaches of using either Volterra based models or ANNs tend to be either cursed with dimensionality or impracticality. In contrast, this disclosure relates to hybrid approaches to allow for extraction of efficient models to cope with ever-increasing levels of radio performance and technical specifications.

Aspects of this disclosure relate to system architectures for Neural Volterra processing. Such systems include operations between digital signal processing (DSP) communications and artificial intelligence/machine learning (AI/ML) compute functions. Systems disclosed herein can include an embedded system that include DSP and AI/ML computing at the edge. DSP and AI/ML computing in systems disclosed herein can complement each other at the user application level.

Embodiments of this disclosure relate to a Neural Volterra actuator. The Neural Volterra actuator can include a first processing block that includes an ANN and a second processing block that includes non-linear gain blocks (for example, look up tables). Multipliers can receive output signals of the second block. A connection circuit can adjust electrical connections to inputs of one or more multipliers. For example, a connection circuit can electrically connect the input of a multiplier to an output of the artificial neural network in a first state and electrically connect the input of the first multiplier to an output of another block (e.g., a delay line) in a second state. This can provide programmability in the Neural Volterra actuator. A combiner can generate a combined output signal based on outputs of the multipliers, where the combined output signal is a digitally predistortion version of an input signal received by the Neural Volterra actuator. The Neural Volterra actuator can provide DPD using Volterra processing and processing by the ANN. The Neural Volterra actuator can be included in a DPD system and provides DPD to reduce non-linearity of a power amplifier.

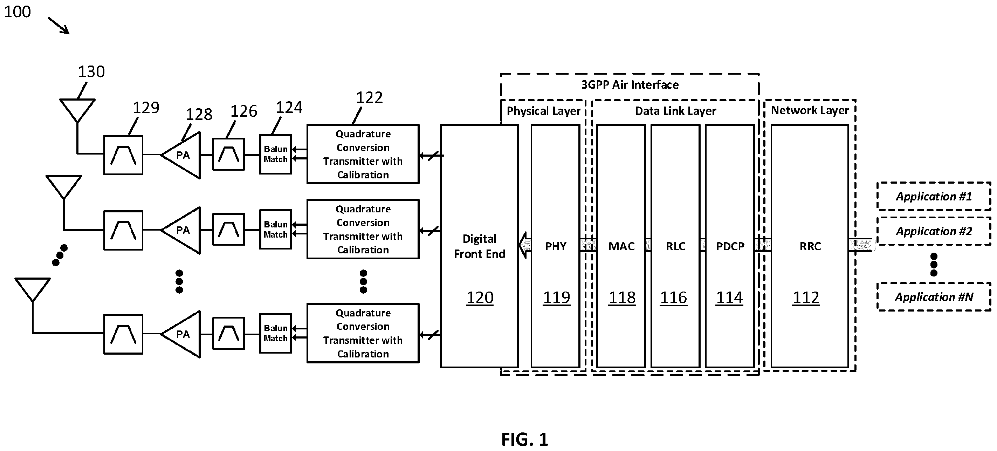

Figure 1 is a schematic diagram of a wireless system 100 that can implement embodiments of this disclosure. As illustrated in Figure 1, the wireless system 100 can include a radio resource control (RRC)112, a packet data convergence protocol (PDCP) 114, a radio link control (RLC) 116, a medium access control (MAC) 118, a physical layer (PHY) 119, a digital front end 120, and a plurality of transmit channels. Each of the transmit channels can include a quadrate conversion transmitter with calibration 122, a balun match 124, a filter 126, a power amplifier (PA) 128, a filter 129, and an antenna 130.

Digital compensation disclosed herein can be implemented in the digital front end 120 of the wireless system 100 of Figure 1. Such digital compensation can enable multi-Tera operations per second (OPS) Neural Volterra processing in a radio unit with edge training and reduced complexity overhead. With edge training, on the fly updates to digital compensation can be implemented. Complete end-to-end inference and training can be implemented. At the same time, the data path can be designed for high performance. The digital compensators disclosed herein can be implemented on a transceiver integrated circuit.

Certain current sample-rate (SR), medium time (MT) DPD, and long time (LT) DPD systems can have drawbacks including redundant operation in a DPD actuator and some sub-models are not designed to be trained on chips. DPD actuators with redundant operations and/or sub-optimal architecture or configuration can consume significant power per chain in a feed forward path at a relatively high sample rate. An estimator, such as a DPD adaptation circuit, can consume also consume significant power. Accordingly, certain sub-models can be trained off chip.

Neural Volterra processing can address these technical challenges and/or other technical challenges for market competitiveness and broad market adoption. At a higher performance level, Neural Volterra processing is expected to consume significantly less power for both an actuator and for an estimator. In addition, a variety of gradient descent algorithms can be used to reduce hardware accelerator specifications for estimation. A neural network actuator can be tuned for running at high sample rates (e.g., sample rates of up to 2 Giga samples per second (GS/s)). Using registers (e.g., flip-flops) instead of static random access memory (SRAM) for weights and lookup tables (LUTs) can reduce power consumption. Neural Volterra processing disclosed herein can provide a desirable combination of area, power, and performance.

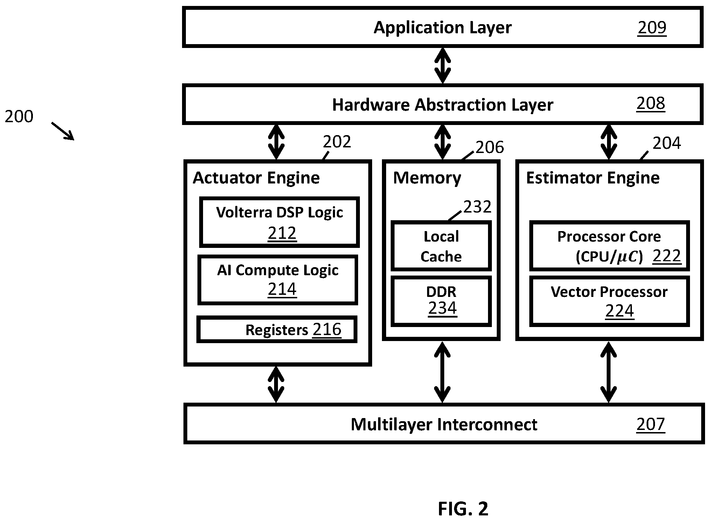

Figure 2 is a schematic block diagram of a Neural Volterra system 200 according to an embodiment. The Neural Volterra system includes actuator inference, estimator training (adaptation), and edge intelligence derived from artificial intelligence (AI) compute logic. The estimator training can be on on-chip training. As illustrated in Figure 2, a digital compensator can include an actuator engine 202, an estimator engine 204, and a memory 206. The digital compensator can be in communication with a multilayer interconnect 207. The digital compensator can also be in communication with a hardware abstraction layer 208. The hardware abstraction layer 208 can be in communication with an application layer 209.

The actuator engine 202 can be in a data path. The actuator engine 202 can operate at relatively high frequency, such as about 2 gigahertz (GHz). The relatively high frequency can be in a range from 1 GHz to 10 GHz in certain applications. The actuator engine can include Volterra DSP logic 212, AI compute logic 214, and registers 216. The AI compute logic 214 can be implemented in a relatively small area in Neural Volterra systems disclosed herein. This can overcome technical challenges related to larger AI compute logic at relatively high frequency. The relatively small AI compute logic 214 can be a significant advantage in Neural Volterra systems over larger AI models of certain ANN systems.

The estimator engine 204 can be included in a feedback path, such as an observation receive path. The estimator engine 204 can operate at a lower frequency than the actuator engine 202. The estimator engine 204 can include a processor core 222 and a vector processor 224. The processor core 222 can be a central processing unit or a microprocessor.

The memory 206 can be significant and perform more functions than in certain existing DPD systems. The memory 206 can be used to enhance and/or optimize an ANN in the AI compute logic 214. This can involve more memory and store operations. The memory 206 can include a local cache 232 and a double data rate (DDR) memory 234. The local cache 232 of the memory 206 can include registers. The memory 206 can save various calibration states of the actuator engine. These calibration states can be obtained and measured during factory calibration or during the research and development phase. In the field, the calibration states stored in the memory 206 can enhance performance to accommodate a variety of use cases.

Hardware accelerators can be designed for both the actuator engine 202 and the estimator engine 204 of the Neural Volterra system 200. With infrequent adaptation, a general graphics processing unit (GPU) can be sufficient. Certain existing solutions can execute inference, but not inference and training. By contrast, embodiments disclosed herein can execute both interference and training. Embodiments of this disclosure can implement both inference and training since Neural Volterra systems disclosed herein can be compact and include relatively small AI compute logic 214.

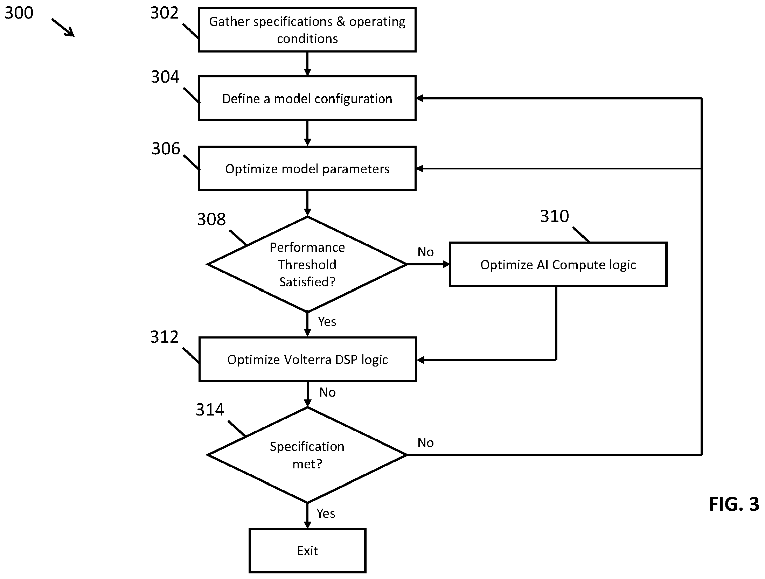

Figure 3 is a flow diagram of a method 300 of Neural Volterra design according to an embodiment. The method 300 can provide a robust Neural Volterra design. Technical specifications and operating conditions can be gathered at block 302. Such technical specifications and operating conditions can include, but are not limited to, instantaneous bandwidth, occupied bandwidth, output power, linearity, and the like. The most stringent use case can be used for training and/or validation purposes.

A model configuration can be defined at block 304. The actuator can be reconfigurable. For instance, a DPD actuator can include roaming LUTs and/or neurons. Alternatively or additionally, the DPD actuator can include a reconfigurable memory depth. The model configuration can be defined based on power and/or area constraints. In certain instances, non-linearity of a power amplifier can be modeled.

Model parameters can be optimized at block 306. A DPD estimator can be reconfigured. This can involve one or more of a variety of optimization algorithms such as least squares optimization, stochastic gradient descent algorithm, etc. Model parameters can be optimized based on power and/or convergence constraints. Power amplifier mode can be inferred and then weights of the model can be inferred.

In certain instances, higher performance can be desired. Performance can be evaluated at block 308. Depending on whether a performance threshold is satisfied, either (1) AI compute logic can be optimized and then Volterra DSP logic can be optimized or (2) Volterra DSP logic can be optimized without optimizing AI compute logic. If higher modeling accuracy from Neural Volterra processing is desired, then AI compute logic (e.g., AI compute logic 214 of Figure 2) can be optimized at block 310. Then Volterra DSP logic can be optimized at block 312. AI compute logic can be updated separately from Volterra DSP logic optimization. If higher modeling accuracy from NeuralVolterra is not desired or needed, Volterra DSP logic (e.g., Volterra DSP logic 212 of Figure 2) can be trained and optimized at block 312 without optimizing AI compute logic at block 310.

If technical specifications are not met for different traffic dynamics at block 314, model configurations and hyperparameters can be optimized at blocks 304 and 306. Otherwise, the Neural Volterra design can be complete and the method 300 can conclude.

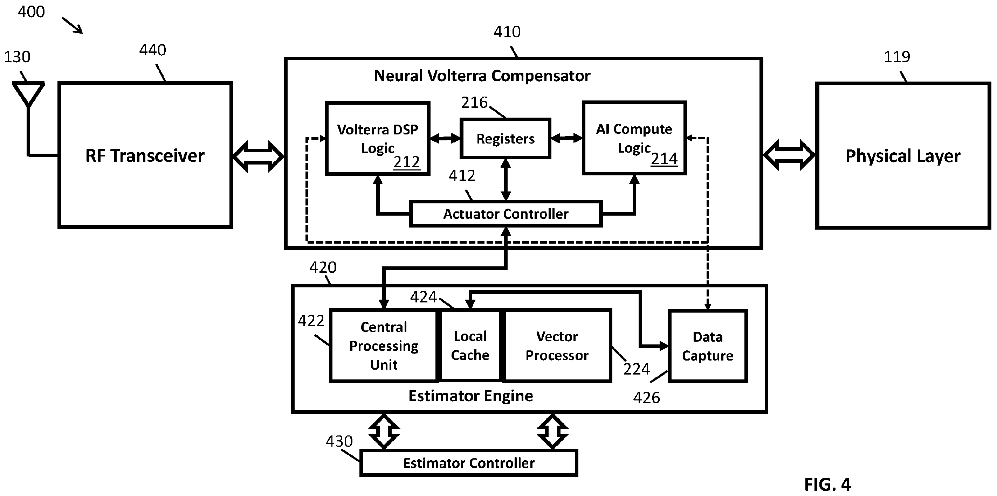

Figure 4 is a schematic block diagram of a Neural Volterra system 400 according to an embodiment. The Neural Volterra system 400 can include a Neural Volterra compensator 410, an estimator engine 420, an estimator controller 430, a physical layer 119, a radio frequency transceiver 440 with calibration, and an antenna 130.

The Neural Volterra compensator 410 can include Volterra DSP logic 212, AI compute logic 214, registers 216, and an actuator controller 412. The Neural Volterra compensator 410 is an example of the actuator engine 202 of Figure 2. The Neural Volterra compensator 410 can be referred to as a Neural Volterra actuator. The Neural Volterra compensator 410 is coupled between the physical layer 119 and the radio frequency transceiver 440. The radio frequency transceiver can have calibration. In the Neural Volterra compensator 410, the Volterra DSP logic 212 and the AI compute logic 214 can be tightly coupled and/or integrated with each other. The Neural Volterra compensator 410 can implement a DPD actuator. Technology disclosed herein can be implemented in a Neural Volterra actuator.

The estimator engine 420 can include a central processing unit 422, a local cache 424, a vector processor 224, and a data capture block 426. The estimator engine 420 is an example of the estimator engine 204 of Figure 2. The estimator engine 420 can implement a DPD adaptation circuit.

The estimator controller 430 can trigger an adaptation routine. The estimator controller 430 can program coefficients from a local cache and/or trigger a processor to program coefficients. The estimator controller 430 can control data capture by the data capture block 426. The estimator controller 430 can monitor the quality of the data prior to solving for the model coefficients. This can safeguard the DPD actuator from getting corrupt coefficients. In other words, the estimator controller 430 can provide robustness and safety measures to the overall actuator and estimator system. The estimator controller 430 can include a processor, microcontroller, or the like. The estimator controller 430 can be implemented by custom logic or general purpose circuitry.

Digital compensators, such as DPD systems, can include a feature processing path, an envelope processing path, multipliers configured to multiply respective output signals of the feature processing path and the envelope processing path, and a combiner configured to combine output signals of the multipliers. Together the feature processing path and the envelope processing path can implement feature engineering. The processing paths, multipliers, and combiner can be included in a DPD actuator. In certain embodiments, the feature processing path can include a feature artificial neural network. In certain embodiments, the envelope processing path can include an envelope artificial neural network. In some embodiments, the feature processing path can include a feature artificial neural network and the envelope processing path can include an envelope artificial neural network. DPD systems disclosed herein can implement sample rate DPD. Alternatively or additionally, DPD systems disclosed herein can implement medium term DPD.

Any suitable principles and advantages disclosed herein can be implemented in combination with any suitable principles and advantages disclosed in U.S. Patent No. 18/747,221, filed June 18, 2024, and titled NEURAL VOLTERRA DIGITAL COMPENSATOR WITH FEATURE NEURAL NETWORK, the disclosure of which is hereby incorporated by reference in its entirety and for all purposes. Any suitable principles and advantages disclosed herein can be implemented in combination with any suitable principles and advantages disclosed in U.S. Patent No. 18/747,230, filed June 18, 2024, and titled NEURAL VOLTERRA DIGITAL COMPENSATOR WITH ENVELOPE NEURAL NETWORK, the disclosure of which is hereby incorporated by reference in its entirety and for all purposes.

The Neural Volterra actuators disclosed herein can be implemented by any suitable circuitry, such as any suitable circuitry of a transceiver integrated circuit. Each processing path, processing block, block, artificial neural network, LUT, multiplier, combiner, or the like of the Neural Volterra actuators disclosed herein is implemented by circuitry, such as circuitry of a transceiver integrated circuit. Any suitable circuitry can implement blocks, artificial neural networks, LUTs, multipliers, combiners, or the like of the Neural Volterra actuators systems disclosed herein in a digital domain.

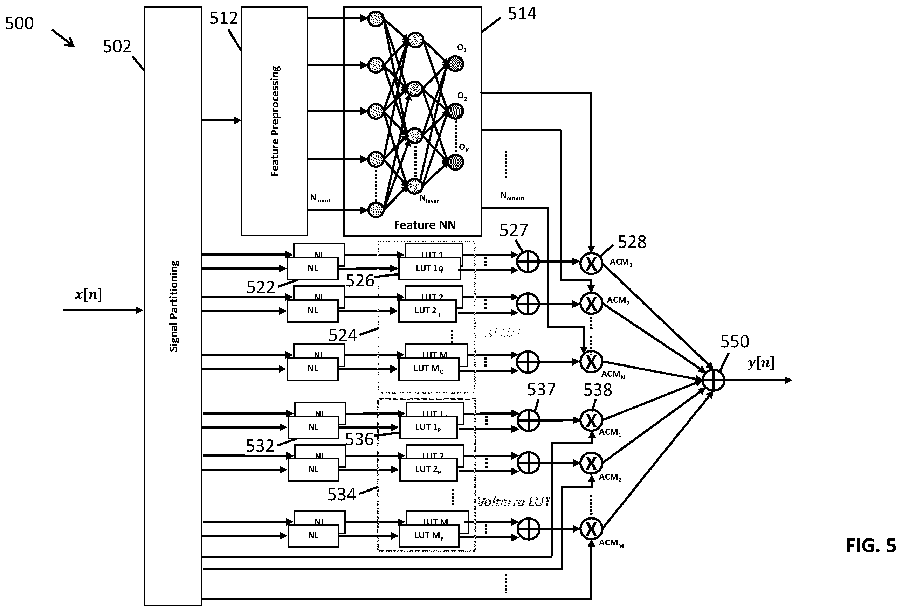

Figure 5 is a schematic diagram of a Neural Volterra actuator 500 according to an embodiment. The Neural Volterra actuator 500 of Figure 5 includes a combination of Neural Volterra processing and Volterra processing. The Neural Volterra actuator 500 is arranged to generate a pre-distorted digital output signal y[n] from a baseband digital input signal x[n]. The input signal x[n] can be a data stream of IQ samples. The input signal x[n] can be a complex digital baseband signal having a real part and an imaginary part.

A signal partitioning block 502 can partition the input signal x[n] for the processing paths of the Neural Volterra actuator 500. The signal partitioning block 502 can also implement a delay. The signal partitioning block 502 can implement a function $x[n - \tau]$ to delay the input signal x[n]. In certain applications, Volterra processing blocks can model different features than the Neural Volterra processing. For example, Volterra processing can model simpler features than the Neural Volterra processing.

The Neural Volterra actuator 500 includes a feature processing path and an envelope processing path. The feature processing path includes a feature preprocessing block 512 and a feature neural network (feature NN) 514. The neural networks disclosed herein are ANNs. The envelope processing path includes non-linear processing blocks 522 and a gain block 524 that includes LUTs 526. Outputs of the LUTs 526 can be summed or otherwise combined by combiners 527 to increase a mapping ratio. Multipliers 528 can multiply outputs of feature processing path with outputs of the envelope processing path.

As discussed above, the feature processing path includes a feature preprocessing block 512 and a feature NN 514. The feature processing path can transform the input signal x[n] in a complex-r-valued domain. Accordingly, the feature processing path can be referred to as a complex feature processing path. The feature processing path can perform a complex-to-complex transformation on the input signal x[n]. This transformation can transform the input signal x[n] to non-linear dynamics, such as non-linear dynamics from DDR models. The complex-to-complex transformation can involve a complex-to-real transformation by the feature preprocessing block and a real-to-complex transformation by the feature NN.

In the Neural Volterra actuator 500, the input signal x[n] can be transformed in a complex-valued domain to a variety of output signals represented in a real-valued domain. The output signals can then be processed by the feature NN 514, creating additional non-linearities, and return the output signals to complex-valued domain before the complex-to-complex multiplication by the multiplier 528.

The feature preprocessing block 512 can generate input features for the feature NN 514 to enhance performance of the IQ samples of the input signal x[n] in the feature NN 514. The feature preprocessing block 512 can perform linear and/or non-linear operations. The input signal x[n] provided to the feature preprocessing block 512 (e.g., via the signal partitioning block 502) has a real part (in-phase component) and an imaginary part (quadrature component). The feature preprocessing block 512 can transform the input signal x[n] from a complex signal to a real signal. In certain applications, the feature preprocessing block 512 can take products of samples of the real part or imaginary part and provide a real output signal to the feature NN 514. Example operations that can be performed by the feature preprocessing block include but are not limited to $Re\{x[n - i]\}, Im\{x[n - i]\}, ... Re\ or\ Im\{x[n - i]|x[n - j]|\}, ... ...$

The feature NN 514 can model any suitable features. The feature NN 514 can receive a real signal from the feature preprocessing block 512. Two outputs of the feature NN 514 can form one complex number provided to a multiplier 528. Because the feature NN 514 provides complex output signals having a real part and an imaginary part, the feature NN 514 can be referred to as a complex feature NN.

In certain instances, the feature NN 514 can be trained offline to determine weights and biases of the feature NN 514. Such offline training can be performed in a factory before deployment of a system that includes the Neural Volterra actuator 500 and/or during foreground calibration before the system that includes the Neural Volterra actuator 500 is operational for RF communication. In some instances, the feature NN 514 can be trained during operation of a system that includes the Neural Volterra actuator 500. This can be referred to as in the field training or online training. The feature NN 514 can be trained using a relatively small amount of a waveform, such as less than 10% or less than 5% of the waveform. As one example, the feature NN 514 can be trained using 49,152 samples or 5% of 983,040 samples (sampling at 983.04 Mega samples per second (MS/s) for a duration of 1 millisecond (ms), 1 subframe of a 5G NR waveform).

The feature NN 514 can include any suitable number of layers and any suitable number of neurons per layer. Layers of the feature NN 514 can be referred to as hidden layers. There can be at least two hidden layers in the feature NN 514. The number of neurons and the number of layers can be relatively small for a neural network. In the example illustrated in Figure 5, there are 3 layers shown in the feature NN 514. Any other suitable number of layers can be implemented in a feature NN in some other applications. Any suitable number of neurons can be implemented in each layer. The Neural Volterra architecture can seamlessly integrate the feature NN 514 into a theoretical Volterra framework. Accordingly, a dependence on relatively large number of hidden layers and neurons can be reduced.

Neurons of the feature NN 514 can be connected any suitable way, such as but not limited to fully connected between layers or partly connected between layers. As illustrated in Figure 5, neurons of the feature NN 514 are fully connected between layers. The feature NN 514 can have any suitable neural network architecture, such as but not limited to a fully connected neural network (FCNN), a convolutional neural network (CNN), or long short-term memory neural network (LSTM NN).

The envelope processing path includes the signal partitioning block 502, an envelope processing block that includes non-linear processing blocks 522, and a gain block 524 that includes LUTs 526. The envelope processing path can be referred to as an envelope feature processing path. The envelope processing path can derive an envelope of the input signal x[n], apply a delay, and apply a gain function.

The signal partitioning block 502 can partition the input signal x[n] for processing by the non-linear processing blocks 522 of the envelope processing block. The signal partitioning block 502 can apply a delay. The signal partitioning block 502 can include one or more delay lines and switching circuitry to time shift and partition the input signal x[n].

The envelope processing block can derive an envelope of the input signal x[n]. This can implement a complex to real transformation. The envelope processing block includes a plurality of non-linear processing blocks 522 that can each operate on a partitioned signal from the signal partitioning block 502. In certain applications, the non-linear processing blocks 522 can perform absolute value computations. The envelope processing block can output an envelope signal from the non-linear processing blocks 522. The envelope signal can have a plurality of components provided by individual non-linear processing blocks 522.

The gain block 524 can apply a gain function to the envelope signal. The gain block 524 can include a plurality of non-linear gain blocks that each apply a non-linear gain on a partition of the envelope signal. As illustrated, the gain block includes LUTs 526. The LUTs 526 are examples of non-linear gain blocks. Each of the LUTs 526 can apply a non-linear grain to a partition of the envelope signal. The LUTs 526 can implement piecewise linear basis functions. For example, the LUTs 526 can implement a weighted sum of basis functions, including orthogonal polynomials, B-splines, or the like. The LUTs 526 can perform a real to complex transformation. The gain block 524 can be referred to an AI gain block. The LUTs 526 can be referred to as an AI LUT. The LUTs 526 and/or any other LUTs disclosed herein can be programmed during operation of a communication system that includes such LUTs. For example, the LUTs 526 can be programmed based on an observation receive signal provided to a transceiver integrated circuit. A DPD adaptation circuit can be used to program the LUTs 526.

Outputs of the LUTs 526 can be summed or otherwise combined by combiners 527. This can increase a mapping ratio. The multipliers 528 can multiply outputs of feature NN 514 with outputs of the combiners 527. In some other applications where combiners 527 are not implemented, the multipliers 528 can multiply outputs of feature NN 514 with outputs of the gain block 524.

The Neural Volterra actuator 500 also includes Volterra processing blocks including non-linear processing blocks 532, a gain block 534 comprising LUTs 536, and a combining block comprising a set of combiners 537. The gain block 534 can be referred to a Volterra gain block. The LUTs 536 can be referred to as a Volterra LUT. A second set of multipliers 538 can multiply outputs of processing paths of the Volterra processing block. The second set of multipliers 538 can multiply output signals from the combining block 537 with respective signals from the signal partitioning block 502. In some applications, the second set of multipliers 538 can multiply output signals from the combining block 537 with respective output signals from a feature preprocessing block. In some other applications where combiners 537 are not implemented, the multipliers 538 can multiply outputs of gain block 534 with outputs of the signal partitioning block and/or outputs of a feature preprocessing block.

A combining block 550 can sum outputs of the multipliers 528 and 538 of the Neural Volterra processing blocks and the Volterra processing blocks.

In certain embodiments, a certain number of LUTs can roam between an AI gain block (e.g., the gain block 524 of Figure 5) and a Volterra gain block (e.g., the gain block 534 of Figure 5). These LUTs and/or other processing blocks in signal chains with these LUTs can be connectable in either the Neural Volterra processing blocks or the Volterra processing block. A subset of the total LUTs of the system of the Neural Volterra actuator 500 can be roaming LUTs.

The Neural Volterra actuator can be defined by a variety of parameters, such as but not limited to the parameters in Table 1. In Table 1, the number of complex-to-complex multiplications for the AI compute logic is represented by $ACM_N$ and the number of complex-to-complex multiplications for the Volterra DSP logic is represented by $ACM_M$.

Table 1

| Neural Volterra Actuator | Notation |
|---|---|
| Memory Depth | $\tau$ |
| # of AI LUTs | $N$ |
| # of Volterra LUTs | $\sum (M,P)$ |
| # of Roaming LUTs | $N_{roaming}$ |
| # of AI ACM | $ACM_N$ |
| # of Volterra ACM | $ACM_M$ |
| # of input features | $i$ |
| # of hidden layers | $l$ |
| # of neurons | $n^{(p)}$ |
| # of roaming neurons | $n^{(romaing)}$ |
| # of output nodes | $l$ |
| # of weights and biases | $\sum_{p=1}^{l} n^{(p)}\left(1 + {}^{*}n^{(p-1)}\right)$ |

There are a variety of scenarios for adaptation use. Four scenarios will be described, including very low complexity, low complexity, medium complexity, and high complexity and high performance. These scenarios will be described with reference to Figure 5.

For very low complexity adaptation, the feature NN 514 can be disabled and a linear regression optimization of Volterra LUTs (e.g., LUTs 536) can be performed in the field. This can bypass the feature NN 514.

For low complexity adaptation, the feature NN 514 can be optimized during foreground calibration or factory calibration and a linear regression optimization of Volterra and AI LUTs (e.g., LUTs 526 and 536, respectively) can be performed in the field. This can involve optimizing the feature NN 514 a priori and freezing the feature NN 514 in the field. Then the LUTs 526 and 536 can be optimized in the field.

For medium complexity adaptation, the feature NN 514 can be infrequently trained in the field and a linear regression optimization of Volterra and AI LUTs (e.g., LUTs 526 and 536, respectively) can be performed in the field. The feature NN 514 can be trained in the field at a relatively low speed. Optimization of the LUTs 526 and 536 can involve going through the middle loop of the flow diagram of Figure 3.

For high complexity and high performance adaptation, a joint optimization of the feature NN 514 and the Volterra and AI LUTs (e.g., LUTs 526 and 536, respectively) can be performed in the field.

Neural Volterra digital compensators can have higher sample rate and smaller artificial neural networks than general purpose neural processing units. General purpose neural processing units have not been seamlessly integrated with the theoretical Volterra framework. Compared to general purpose neural processing units, such digital compensators can have a lower number of weights, lower reconfigurability (low to medium versus high), significantly higher utilization (very high versus low), slightly higher area, and lower power. In addition, weights and bias/scale can be stored in registers (e.g., dedicated registers) in Neural Volterra digital compensators. In Neural Volterra digital compensators, the number of neurons in an accelerator can be the same as the number of the neurons in a model for processing at high data rates.

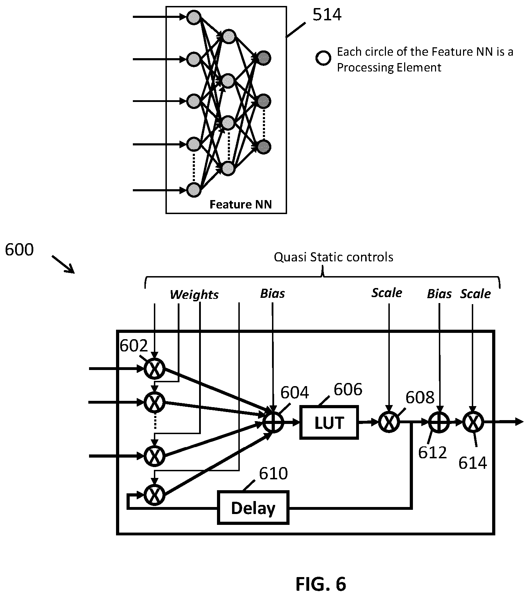

Artificial neural networks in Neural Volterra digital compensators can include a custom NN with neurons and hard connections. Figure 6 includes schematic diagram of a neural processing element 600 according to an embodiment. The neural processing element 600 can implement a neuron in an artificial neural network. For example, the neural processing element 600 can implement a neuron in the feature NN 514. In certain applications, each neuron of the feature NN 514 is implemented by the neural processing element 600. The neural processing element 600 can be referred to as a node in an artificial neural network. Each neural processing element 600 can include 1 sum of product block followed by 1 interpolated LUT/SRAM for an actuator function. $n^{(p)} \in \mathbb{R}$ can represent a number $n$ of layer $p$ neurons. Each neural processing element 600 can have:

$n^{(p-1)}$ inputs: 1 output $\rightarrow i^{bt}$ bits each
$n^{(p-1)}$ weights $\rightarrow w^{bt}t$ bits each (fully Connected)

As illustrated in Figure 6, a sum of product block can include multipliers 602 that multiply inputs by corresponding weights and a summer 604 that can sum output signals of the multipliers 602. The summer 604 can also sum a bias with the output signals of the multipliers 602. An actuator function can be implemented by a LUT 606. The actuator function can be referred to as an activation function. The actuator function can be applied to an output signal from sum of product block. The LUT 606 can be an actuation LUT $\rightarrow i^{bt}$ bit $2^{ibt-k}$ deep SRAM with interpolation. In this expression, variable k is a design tradeoff. Smaller k implies a deeper LUT or memory. For connections/nodes not present, weights can be disabled. A scaled output of the actuation LUT 606 can be delayed and fed back to the sum of product block.

In the neural processing element 600, a multiplier 608 can scale an output signal from the LUT 606 and a delay circuit 610 can delay an output signal from the multiplier and provide an output signal to one of the multipliers 602. The output signal from the multiplier 608 can also be adjusted by a summer 612 and scaled by a multiplier 614. The weights, biases, and scaling factors can be provided to the neural processing element 600 by quasi static controls. The quasi static controls include or be attached to a register bank.

Each neural processing element 600 of Figure 6 can be a unit cell in a NN. An array of such neural processing elements 600 can be included in a NN. A neural processing element 600 can have a 1 cycle compute.

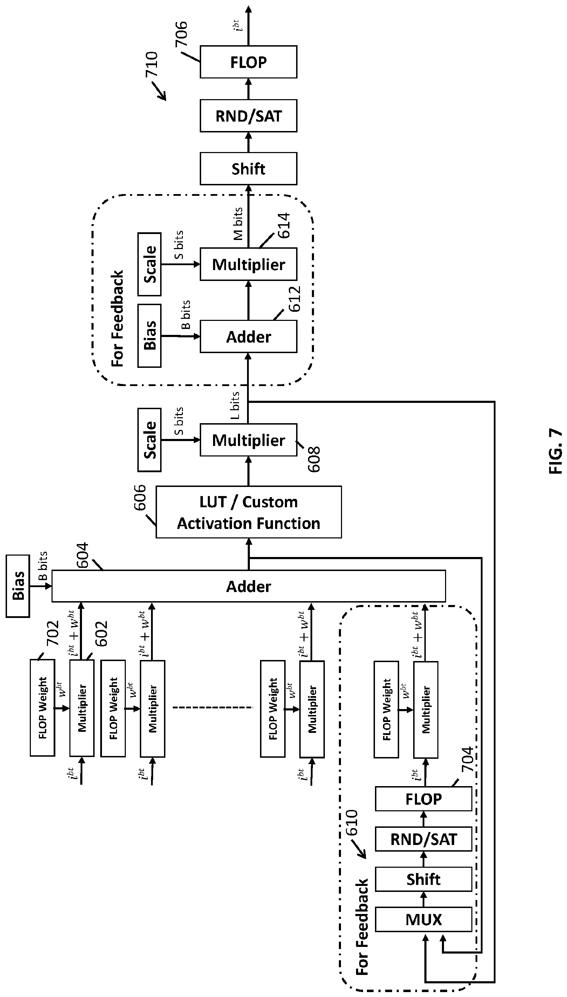

Figure 7 is a schematic diagram of an embodiment of the neural processing element 600 of Figure 6. State elements, such as flip-flops and/or latches, can be implemented in some applications. State elements 702 can provide weights to multipliers 602. The delay circuit 610 can include a state element 704. An output state element 706 can also be included. The location of the state elements can depend on timing specifications. The location of the shift and round (RND) blocks in the dataflow (e.g., in the delay circuit 610 and a shift and round circuit 710) can vary depending on a particular application. In some instances, interpolation can be added to the LUT 606 that implements an activation function.

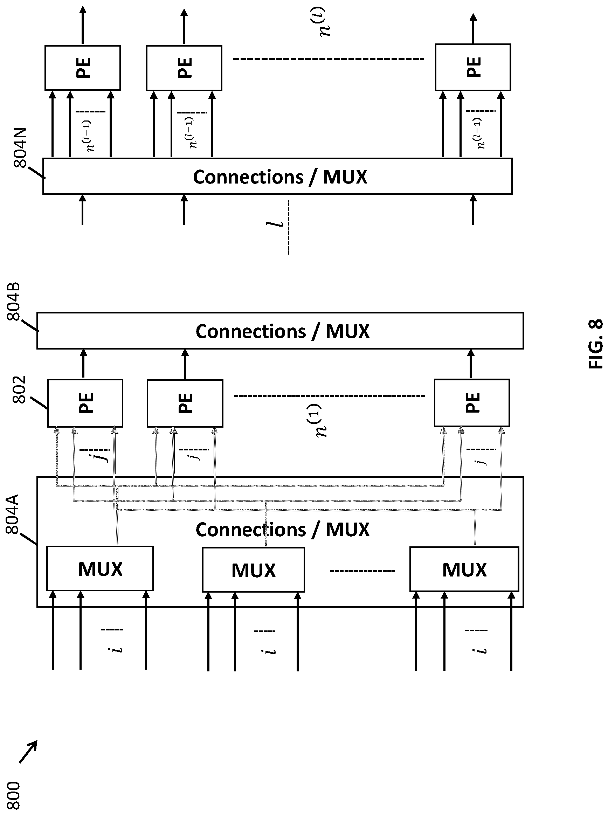

Figure 8 is a schematic diagram of components of a neural actuator 800 according to an embodiment. The neural actuator 800 can be a sample rate neural actuator. In the neural actuator 800, neural processing elements (PEs) 802 can be arranged with a degree of freedom. Although one neural processing element 802 is given a reference number in Figure 8, each of the neural processing elements labeled PE can be a neural processing element generally referred to as neural processing element 802. A neural processing element 802 can implement a neuron in an ANN. Each neural processing element 802 can be implemented in accordance with any suitable principles and advantages discussed with reference to Figure 6 and/or Figure 7. In certain applications, each of the neural processing elements 802 can have a plurality of inputs and 1 output. Such neural processing elements 802 can each receive inputs from neural processing elements 802 in another layer of an artificial neural network. A connection circuit 804A, 804B, ..., 804N can selectively connect an output of each neural processing element 802 to any neural processing element(s) 802 of a subsequent layer of the artificial neural network. Models can be developed and the connection circuits 804A to 804N can be used to optimize connections between neural processing elements 802 for such models. In Figure 8, the connection circuits 804A to 804N are labeled as Connections/Mux. In the neural actuator 800, there are more inputs (i) to a first connection circuit 804 than outputs (j) of the first connection circuit 804.

The connection circuits 804A to 804N can interconnect two layers of the artificial neural network and/or provide connections to a first layer of the artificial neural network. In some applications a connection circuit can provide connections from a last layer of the artificial neural network to output nodes. The connection circuits 804A to 804N can provide any suitable combination of fixed connections and/or reconfigurable connections depending on the particular application. In some applications, certain neural processing elements 802 have fixed connections and some other neural processing elements 802 can have reconfigurable input and/or output connections. A neural processing element 802 with reconfigurable input and output connections can be referred to as a floating neural processing element.

With connection circuits 804A to 804N, the artificial neural network can be reconfigured. As an example, a sensor input can be provided to the artificial neural network. The sensor input can be indicative of a system state, such as temperature, usage, etc. Based on the sensor input, the connection circuits 804A to 804N can adjust connections between neural processing elements 802 to reconfigure the artificial neural network. As another example, an artificial neural network can receive an external input signal provided from external to a transceiver integrated circuit. For instance, an external input signal can be a digital signal or a periodic sequence that carries certain timing information. In a time interleaving architecture, the rising edge and falling edge of the clock can be an external input to trigger a neural actuator to learn certain behavior near the clock edge. In some applications, the external input signal can be a Time Division Duplex (TDD) trigger signal, where the rising edge of the TDD trigger signal can inform the neural actuator that valid data is coming to a radio, and hence train the neural actuator to compensate for any non-ideal behavior happening during the transition of the TDD signal from data off to data on. Based on any suitable external input signal, the connection circuits 804A to 804N can adjust connections between neural processing elements to reconfigure the artificial neural network.

A first connection circuit 804A can adjust connections between a feature preprocessing block (e.g., the feature preprocessing block 512 of Figure 5) and inputs to an artificial neural network (e.g., the feature NN 514 of Figure 5). Accordingly, mapping from a processing block to an artificial neural network can be programmable in DPD actuators disclosed herein.

In some other applications, a general purpose neural processing unit can be used for a sample rate neural actuator.

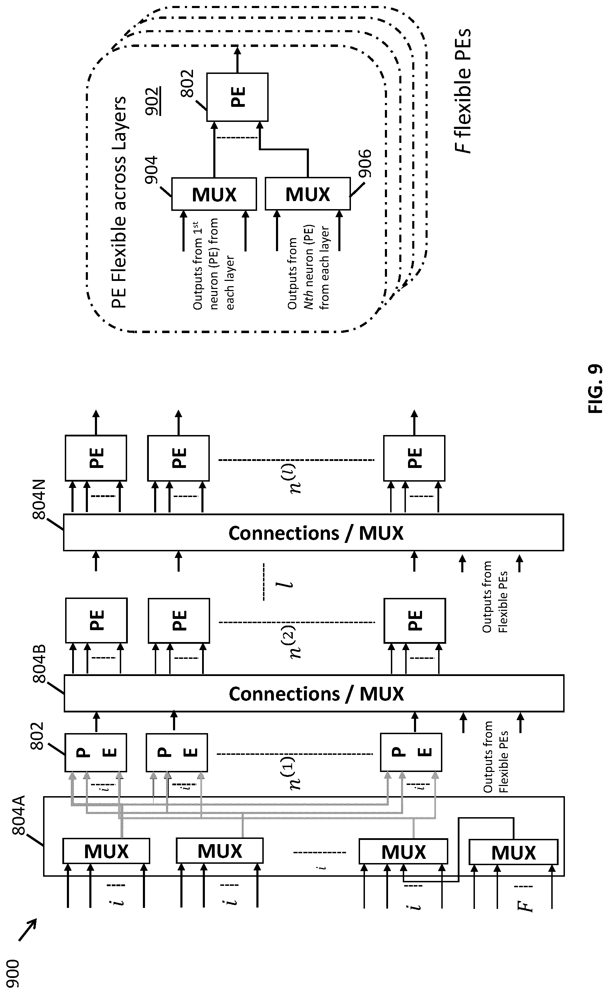

Figure 9 is a schematic diagram of a reconfigurable neural actuator 900 according to an embodiment. The reconfigurable neural actuator 900 can be a sample rate neural actuator. In the reconfigurable neural actuator 900, flexible neural processing elements 902 can be connected to any other suitable neural processing elements 802 in the artificial neural network. The flexible neural processing elements 902 can be included in any suitable layer of the artificial neural network. With the flexible neural processing elements 902, neural processing elements can be included with any suitable connections in the artificial neural network. In certain instances, some neural processing elements of an artificial neural network can be flexible neural processing elements 902 and other neural processing elements 802 can have fixed connections. In some other instances, all neural processing elements can be flexible neural processing elements 902. A flexible neural processing element 902 can implement a neural in an ANN.

As illustrated in Figure 9, a flexible neural processing element 902 can include a processing element 802 and multiplexers 904 and 906 that receive outputs from neural processing elements 802 in a plurality of layers (e.g., each layer). The multiplexers 904 and 906 can provide selected output signals from neural processing elements 802 of one or more other layers to the neural processing element 802 of the flexible neural processing element 902. Outputs from flexible neural processing elements 902 can be provided to connection circuits 804A, 804B, ..., 804N of the artificial neural network. Together the multiplexers 904 and 906 of the flexible neural processing elements 902 and the connection circuits 804A to 804N can provide flexible connections in a reconfigurable neural network.

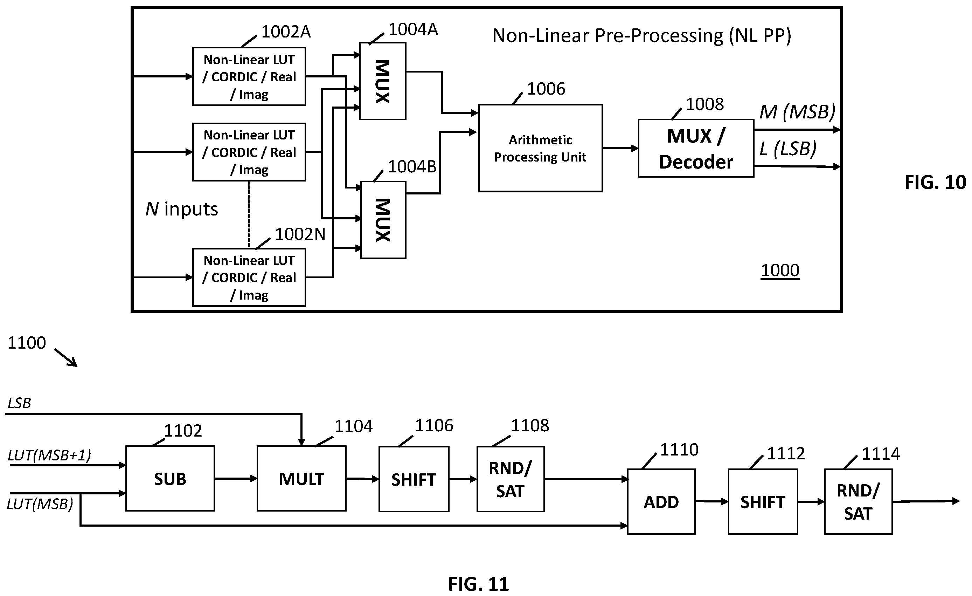

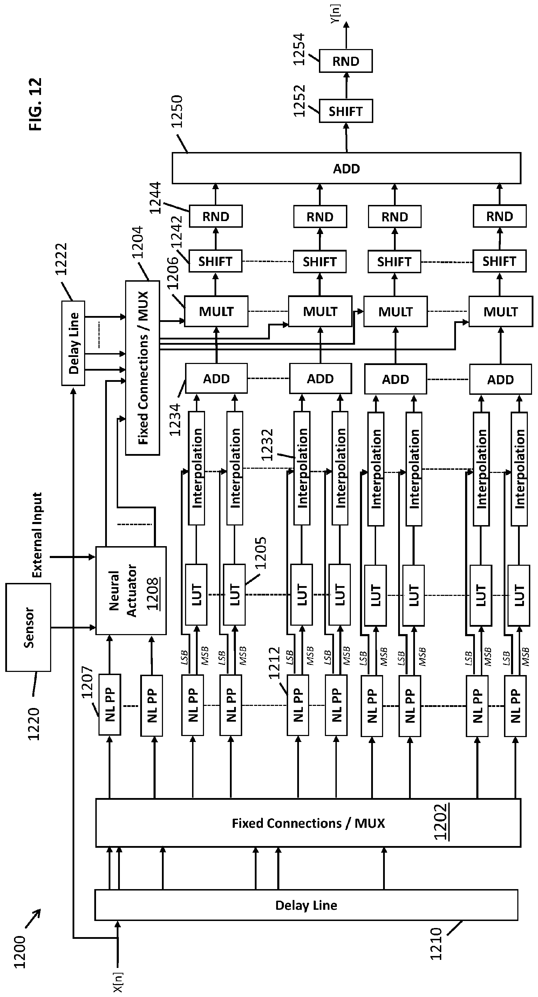

Figure 10 is a schematic block diagram for a non-linear pre-processing block 1000 according to an embodiment. The non-linear pre-processing block 1000 can implement a non-linear processing block 522 or 532 of Figure 5 and/or a feature preprocessing block 512 of Figure 5 and/or a non-linear processing block 1207 and/or 1212of Figure 12. As illustrated in Figure 10, the non-linear pre-processing block 1000 can include non-linear processing elements 1002A to 1002N, multiplexers 1004A and 1004B, an arithmetic processing unit 1006, and an output multiplexer / decoder 1008. The non-linear processing elements 1002 to 100N can each include one or more of a non-linear LUT, a coordinate rotation digital computer (CORDIC) or the like. The arithmetic processing unit 1006 can include one or more of an add, mean, difference, or multiplication block. The output signals from the non-linear pre-processing block 1000 can be used to address a LUT.

In certain applications, LUT interpolation can be implemented. LUT interpolation can be linear, quadradic, spline, etc. Figure 11 is a schematic block diagram for a linear LUT interpolation block 1100. The linear LUT interpolation block 1100 can multiply a least significant bit (LSB) by a difference between LUT values of the two nearest most significant bits (MSBs), then shift and round the result. After rounding, the LUT value corresponding to the lower of two nearest MSBs can be added, then shifting and rounding can be performed. The result of these operations can be linear interpolation. As illustrated, the linear LUT interpolation block 1100 can include a subtractor 1102, a multiplier 1104, a shifter 1106, a rounder 1108, an adder 1110, a shifter 1112, and a rounder 1114 to perform these operations. LUT interpolation can be implemented in accordance with any suitable principles and advantages disclosed in U.S. Patent No. 11,558,078, the disclosure of which is hereby incorporated by reference in its entirety and for all purposes.

Figure 12 is a schematic diagram of a Neural Volterra actuator 1200 according to an embodiment. In Figure 12, lines between blocks that cross each other indicate that the crossing lines are included in separate connections and are not electrically connected. The Neural Volterra actuator 1200 is programmable. The architecture of Neural Volterra actuator 1200 allows for configurability. In the Neural Volterra actuator 1200, the connection circuits 1202 and 1204 can program different connections for processing paths. Certain LUTs 1205 can roam such that these LUTs are either (1) included in an AI gain block of a processing path with outputs that are multiplied by outputs of a processing path that includes an artificial neural network or (2) included in a Volterra gain block. The connection circuit 1204 can adjust connections to multipliers 1206 so that LUTs 1205 are either included in the AI gain block or the Volterra gain block. Non-linear pre-processing (NL PP) blocks 1207 in a processing path of the Neural Volterra actuator that includes a neural actuator 1208 can include multiplexers that can adjust connections to the neural actuator 1208. Such NL PP blocks 1207 can be implemented in accordance with any suitable principles and advantages of the NL PP block 1000 of Figure 10, for example. The neural actuator 1208 can include a feature NN, for example. Such a feature NN can be the feature NN 514 of Figure 5 in certain applications. The neural actuator 1208 can be programmable in accordance with any suitable principles and advantages disclosed herein.

The Neural Volterra actuator 1200 includes a first processing block and a second processing block. The first processing block performs neural processing. The first processing block of the Neural Volterra actuator 1200 includes the NL PP blocks 1207 and the neural actuator 1208. The neural actuator 1208 includes an ANN, such as the features NN of 512 of Figure 5. The second processing block performs Volterra processing. The second processing block of the Neural Volterra actuator 1200 includes the NL PP blocks 1212 and the LUTs 1205. The NL PP bocks 1207 provide output signals to the neural actuator 1208. The NL PP blocks 1212 provide output signals to the LUTs 1205. In certain applications, the NL PP bocks 1207 and the NL PP blocks 1212 can be implemented similarly or be different instantiations of the same block. The second processing block can also include interpolation blocks 1232 and a set of combiners 1234. The multipliers 1206 are configured to receive output signals of the second processing block. The inputs of the multipliers 1206 can have fixed connections with outputs of the second processing block.

The connection circuit 1204 can adjust electrical connections to inputs of one or more multipliers 1206. The connection circuit 1204 can selectively electrically connect one or more outputs of the neural actuator 1208 to respective inputs of multipliers 1206. For example, the connection circuit 1204 can electrically connect the input of a multiplier 1206 to an output of the neural actuator 1208 in a first state and electrically connect the input of the multiplier 1206 to an output of the delay line 1222 in a second state. This can configure Neural Volterra processing. The connection circuit 1204 can alternatively or additionally selectively electrically connect one or more outputs of a delay line 1222 to respective inputs of multipliers 1206. This can configure Volterra processing. Accordingly, the connection circuit 1204 can configure either Neural Volterra processing or Volterra processing by selectively electrically connecting inputs to the multipliers 1206.

In the Neural Volterra actuator 1200, a baseband digital input signal x[n] can be delayed by a delay line 1210 and then partitioned by the connection circuit 1202. The connection circuit 1202 can include any suitable number of fixed connections and any suitable multiplexing functionality. The connection circuit 1202 can provide programmability. Outputs of the connection circuit 1202 are provided to NL PP blocks 1212. The NL PP blocks 1212 can be implemented in accordance with any suitable principles and advantages of the NL PP block 1000 of Figure 10, the non-linear processing blocks 522, the non-linear processing blocks 532 and/or other non-linear processing blocks disclosed herein.

A processing path, such as a feature processing path, can include a neural actuator 1208 (e.g., a feature NN, such as the feature NN 514 of Figure 5) that receives signals from NL PP blocks 1207. These NL PP blocks 1207 can implement a feature preprocessing block, such as the feature preprocessing block 512 of Figure 5. The neural actuator 1208 can receive an input signal from a sensor 1220. The neural actuator 1208 can receive an input signal from an external input. The neural actuator 1208 can adjust connections between neural processing elements of the neural actuator 1208 based on the input signal from the sensor 1220 and/or the external input. The neural actuator 1208 can adjust connections between neural processing elements in accordance with any suitable principles and advantages disclosed herein, for example, as discussed with reference to Figure 8 and/or Figure 9. For example, connections between neural processing elements can be adjusted with one or more connection circuits 804A to 804N of Figure 8 or Figure 9. Alternatively or additionally, connections between neural processing elements can be adjusted using one or more multiplexers of one or more flexible neural processing elements 902. Each neural processing element can be implemented with any suitable principles and advantages discussed with reference to Figure 6 and/or Figure 7 and/or Figure 9.

A connection circuit 1204 can selectively provide output signals from the neural actuator 1208 to multipliers 1206 for multiplying with output signals from another processing path. The connection circuit 1204 can also selectively provide output signals from a delay line 1222 to one or more of the multipliers 1206. The connection circuit 1204 can include any suitable number of fixed connections and any suitable multiplexing functionality.

The connection circuit 1204 can configure the Neural Volterra actuator 1200 to perform (1) multiplications between output signals from the neural actuator 1208 and processing paths that include a NL PP 1212 and a LUT 1205 and (2) multiplications between output signals from the delay line 1222 and processing paths that include a NL PP 1212 and a LUT 1205. The multipliers 1206 can be configurable to perform multiplications like multipliers 528 of Figure 5 or multiplications like multipliers 538 of Figure 5. With the connection circuit 1204, the Neural Volterra actuator 1200 can selectively provide signals from either the neural actuator 1208 or the delay line 1222 to multipliers 1206. Gain blocks (e.g., LUTs 1205) of the Neural Volterra actuator 1200 can be used as part of an AI gain block (e.g., the gain block 524 of Figure 5) or a Volterra gain block (e.g., the gain block 534 of Figure 5) based on how the connection circuit 1204 connects the neural actuator 1208 and the delay line 1222 to the multipliers 1206 of the Neural Volterra actuator 1200.

Processing paths of the Neural Volterra actuator 1200 include non-linear gain blocks (e.g., LUTs 1205). In some instances, interpolation blocks 1232 can perform interpolation (e.g., linear interpolation of Figure 11 and/or other suitable interpolation) on signals provided by the non-linear gain blocks. The interpolation blocks can receive a LSB from a respective NL PP block 1212 in a signal chain for interpolation. Interpolation blocks 1232 are not included in some applications. Output signals from signal chains that include NL PP blocks 1212 and non-linear gain blocks (e.g., LUTs 1205) can be combined (e.g., added) using a set of combiners 1234 to increase a mapping ratio. Output signals from this set of combiners 1234 can be multiplied by output signals provided by the connection circuit 1204, such as output signals of the neural actuator 1208.

Output signals of the multipliers 1206 can be shifted and rounded, for example, using a shifter 1242 and a rounder 1244, respectively. A combiner 1250 can generate a combined signal based on outputs of the multipliers 1206. Then combined signal can be shifted and rounded, for example, using a shifter 1252 and a rounder 1254, respectively. An output signal y[n] provided by the Neural Volterra actuator 1200 can be a digitally predistorted version of the input signal x[n]. The output signal y[n] can be a digital baseband signal.

In certain applications, there can be multiple pipeline stages in the Neural Volterra actuator 1200.

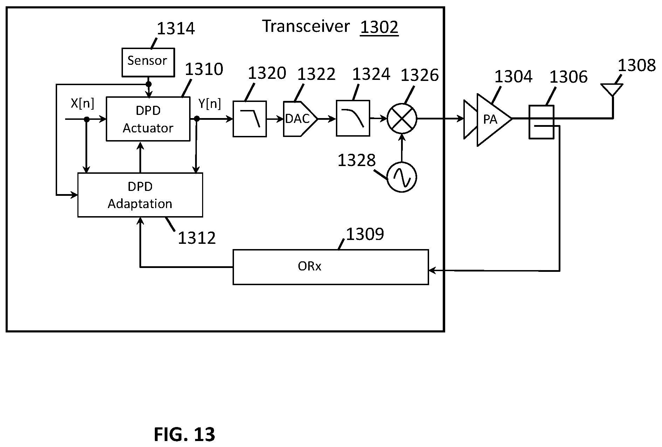

Communication systems can include transceiver integrated circuits that include DPD systems disclosed herein. Figure 13 is a schematic diagram of a communication system 1300 that includes DPD according to an embodiment. As illustrated, the communication system 1300 includes a transceiver integrated circuit 1302, a power amplifier 1304, a radio frequency coupler 1306, and an antenna 1308.

The transceiver integrated circuit 1302 can provide a radio frequency signal for amplification by the power amplifier 1304. The antenna 1308 can wirelessly transmit the amplified radio frequency signal provided by the power amplifier 1304. In some applications, a communication system 1300 can include a relatively large number of antennas and/or perform beamforming. The radio frequency coupler 1306 can provide an indication of power of the radio frequency signal provided to the antenna 1308 to the transceiver integrated circuit.

The transceiver integrated circuit 1302 can include a DPD system, a transmitter, and an observation receiver 1309. The DPD system of the transceiver integrated circuit 1302 includes a DPD actuator 1310 and a DPD adaptation circuit 1312. The DPD actuator 1310 can be implemented in accordance with any suitable principles and advantages of any of the DPD actuators and/or Neural Volterra actuators disclosed herein. As shown in Figure 13, the DPD actuator 1310 can receive a sensor input signal from a sensor 1314 of the transceiver integrated circuit 1302. The sensor input can be provided to one or more artificial neural networks of the DPD actuator 1310. The sensor 1314 can be any suitable sensor, such as but not limited to a temperature sensor, a supply voltage sensor, a VSWR sensor, or the like. In some applications, the transceiver integrated circuit 1302 can include two or more sensors 1314.

The observation receiver 1309 can process the indication of radio frequency power from the radio frequency coupler 1306 and provide an observation receive input to the DPD adaptation circuit 1312. The DPD adaptation circuit 1312 can also receive an input signal x[n] and an output signal y[n] of the DPD system. In addition, the DPD adaptation circuit 1312 can receive the sensor input signal from the sensor 1314. The DPD adaptation circuit 1312 can update predistortion coefficients and provide the updated predistortion coefficients to the DPD actuator 1310.

The DPD actuator 1310 can provide a digitally pre-distorted output signal y[n] to a transmitter. The transmitter can include a digital filter 1320, a digital-to-analog converter 1322, an analog filter 1324, and an upconverter 1326 that is connected to an oscillator 1328. A variety of other transmitter architectures can be used in some other applications, such as transmitters with digital upconverters, etc. The transmitter can include in-phase and quadrature paths, where the illustrated transmitter path is one of the in-phase path or the quadrature path.

This disclosure provides Neural Volterra system architectures for a hardware accelerator engine. The hardware accelerator engine can include Volterra DSP logic and AI compute logic. Aspects of the system architecture can include one or more of neural processing elements, a neural actuator, a re-configurable neural actuator, non-linear neural preprocessing blocks, or a Neural Volterra accelerator.

Neural Volterra system architectures can be reconfigurable. Roaming LUTs can be configurable as either part of an Volterra gain block or an AI compute gain block. Roaming neural processing elements can be connectable in an artificial neural network in a variety of different ways.

System architectures disclosed herein can involve edge training and edge inference.

Different on-chip adaptation schemes can be used for partial and/or full updates.

In embodiments of this disclosure, circuits, systems and methods are described in connection with particular embodiments. It will be understood, however, that any suitable principles and advantages of the embodiments of this disclosure can be used for any other systems, apparatus, electronic devices, or methods with a need for the technology disclosed herein, such as DPD systems or other digital compensators. Moreover, any suitable principles and advantages disclosed herein can be implemented in systems and in methods that include a DPD system for reducing non-linearity of a power amplifier. The elements and acts of the various embodiments of this disclosure can be combined to provide further embodiments. The acts of the methods discussed herein can be performed in any order as appropriate. Moreover, the acts of the methods discussed herein can be performed serially or in parallel, as appropriate.

The principles and advantages described herein can be implemented in various apparatuses. Examples of such apparatuses can include, but are not limited to, communications infrastructure such as wireless communications infrastructure, consumer electronic products, parts of the consumer electronic products, electronic test equipment, vehicular electronics products, industrial electronics products, etc. Electronic products can include, but are not limited to, base stations such as cellular base stations, access points, repeaters, relays, wireless communication devices, a mobile phone (for example, a smart phone), a hand-held computer, a tablet computer, a laptop computer, a wearable computing device, a vehicular electronics system, a radio, a wearable health monitoring device, etc. Further, apparatuses can include unfinished products.

Conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or whether these features, elements and/or states are included or are to be performed in any particular embodiment.

Unless the context clearly requires otherwise, throughout the disclosure and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used in this disclosure, refer to two or more elements that may be either directly connected, or connected by way of one or more intermediate elements. Additionally, the words "herein," "above," "below," and words of similar import, when used in this application, shall refer to this application as a whole and not to any particular portions of this application.

Where the context permits, words in this disclosure using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values provided herein are intended to include similar values within a measurement error.

While certain embodiments have been described, these embodiments have been presented by way of example only, and are not intended to limit the scope of the disclosure. Indeed, the circuits, systems, and methods of this disclosure may be embodied in a variety of other forms. Furthermore, various omissions, substitutions and changes in the form of the methods, circuits, modules, and systems described herein may be made without departing from the spirit of the disclosure. Such changes and modifications are to be understood as being included within the scope of the disclosure. For example, while blocks are presented in a given arrangement, alternative embodiments may perform similar functionalities with different components and/or circuit topologies, and some blocks may be deleted, moved, added, subdivided, combined, and/or modified. Each of these blocks may be implemented in a variety of different ways. Any suitable combination of the elements and acts of the various embodiments described herein can be combined to provide further embodiments. The various features and processes described above may be implemented independently of one another or may be combined in various ways. All possible combinations and sub-combinations of features of this disclosure are intended to fall within the scope of this disclosure.

Numbered aspects

By way of non-limiting example, some aspects of the disclosure are set out in the following numbered clauses.

Numbered Clause 1. A Neural Volterra actuator comprising:

a first processing block comprising an artificial neural network;
a second processing block comprising a non-linear gain blocks;
multipliers configured to receive output signals of the second processing block, the multipliers comprising a first multiplier and a second multiplier;
a connection circuit having an input connected to an output of the artificial neural network, the connection circuit configured to adjust an electrical connection to an input of the first multiplier; and
a combiner configured to generate a combined output signal based on output signals from the multipliers and to output the combined output signal, wherein the combined output signal is a digitally predistorted version of an input signal received by the Neural Volterra actuator.

Numbered Clause 2. The Neural Volterra actuator of Numbered Clause 1, wherein the connection circuit comprises a fixed connection between a second output of the artificial neural network and the second multiplier.

Numbered Clause 3. The Neural Volterra actuator of C Numbered Clause laim 1 or 2, wherein the connection circuit is configured to electrically connect an input of the second multiplier to either a second output of the artificial neural network or an output of a delay line.

Numbered Clause 4. The Neural Volterra actuator of any preceding Numbered Clause, wherein the connection circuit is configured to electrically connect an input to the second multiplier to either a second output of the artificial neural network or an output of a signal partitioning block.

Numbered Clause 5. The Neural Volterra actuator of any preceding Numbered Clause, wherein the connection circuit is configured to electrically connect the input of the first multiplier to the output of the artificial neural network in a first state and to electrically connect the input of the first multiplier to an output of a delay line in a second state.

Numbered Clause 6. The Neural Volterra actuator of any preceding Numbered Clause, wherein the artificial neural network comprises neurons and programmable connections between the neurons.

Numbered Clause 7. The Neural Volterra actuator of Numbered Clause 6, wherein the neurons comprises roaming neurons.

Numbered Clause 8. The Neural Volterra actuator of Numbered Clause 6 or 7, wherein a neuron of the neurons comprises a look up table and feedback path from a scaled output of the look up table.

Numbered Clause 9. The Neural Volterra actuator of any Numbered Clause, wherein the artificial neural network comprises programmable connections between neurons in different layers of the artificial neural network.

Numbered Clause 10. The Neural Volterra actuator of any preceding Numbered Clause, wherein the first processing block comprises a plurality of non-linear preprocessing blocks having outputs connected to inputs of the artificial neural network.

Numbered Clause 11. The Neural Volterra actuator of any preceding Numbered Clause, further comprising a second connection circuit configured to adjust electrical connections to non-linear preprocessing blocks, and wherein second processing block comprises the non-linear preprocessing blocks, and wherein the non-linear preprocessing blocks have outputs connected to inputs of the non-linear gain blocks.

Numbered Clause 12. The Neural Volterra actuator of any preceding Numbered Clause, wherein the artificial neural network is configured to receive a signal from a sensor.

Numbered Clause 13. A method of configuring a Neural Volterra actuator for digital predistortion, the method comprising:

  electrically connecting an output of an artificial neural network to an input of a multiplier with a connection circuit such that the multiplier is configured to multiply an output signal from the artificial neural network with a signal from a second processing path that includes a non-linear gain block;
  wherein the Neural Volterra actuator comprises the artificial neural network, the connection circuit, a plurality of multipliers comprising the multiplier, a plurality of non-linear gain blocks comprising the non-linear gain block, and a combiner configured to generate a combined output signal based on output signals from the plurality of multipliers, and
  wherein the combined output signal is a digitally predistorted version of an input signal received by the Neural Volterra actuator.

Numbered Clause 14. The method of Numbered Clause 13, further comprising adjusting an electrical connection to the input of the multiplier with the connection circuit such that an output of a signal partitioning block is provided to the input of the multiplier.

Numbered Clause 15. The method of Numbered Clause 13 or 14, further comprising adjusting connections between neurons of the artificial neural network in different layers of the artificial neural network.

Numbered Clause 16. The method of any of Numbered Clauses 13 to 15, wherein the connection circuit provides a fixed connection between a second output of the artificial neural network and an input of a second multiplier of the plurality of multipliers.

Numbered Clause 17. The method of any of Numbered Clauses 13 to 16, wherein the second processing path comprises a non-linear preprocessing block having an output connected to an input of the non-linear gain block, and the method further comprises setting a connection to an input of the non-linear preprocessing block with a second connection circuit.

Numbered Clause 18. A system with digital predistortion, the system comprising:
a transceiver integrated circuit comprising a digital predistortion system, the digital predistortion system comprising a Neural Volterra actuator, the Neural Volterra actuator comprising:

  a first processing block comprising an artificial neural network;
  a second processing block comprising a non-linear gain blocks;

multipliers configured to receive output signals of the second processing block, the multipliers comprising a first multiplier and a second multiplier;

a connection circuit having an input connected to an output of the artificial neural network, the connection circuit configured to adjust an electrical connection to an input of the first multiplier; and

a combiner configured to generate a combined output signal based on output signals from the multipliers and to output the combined output signal, wherein the combined output signal is a digitally predistorted version of an input signal received by the Neural Volterra actuator; and

a power amplifier in communication with the transceiver integrated circuit, the digital predistortion system configured to reduce a non-linearity of the power amplifier.

Numbered Clause 19. The system of Numbered Clause 19, further comprising an antenna in communication with the power amplifier.

Numbered Clause 20. The system of Numbered Clause 19 or 20, further comprising a sensor, the artificial neural network configured to receive a sensor signal from the sensor.

**Claims**

1. A Neural Volterra actuator comprising:

   a first processing block comprising an artificial neural network;

   a second processing block comprising a non-linear gain blocks;

   multipliers configured to receive output signals of the second processing block, the multipliers comprising a first multiplier and a second multiplier;

   a connection circuit having an input connected to an output of the artificial neural network, the connection circuit configured to adjust an electrical connection to an input of the first multiplier; and

   a combiner configured to generate a combined output signal based on output signals from the multipliers and to output the combined output signal, wherein the combined output signal is a digitally predistorted version of an input signal received by the Neural Volterra actuator.

2. The Neural Volterra actuator of Claim 1, wherein the connection circuit comprises a fixed connection between a second output of the artificial neural network and the second multiplier.

3. The Neural Volterra actuator of Claim 1 or 2, wherein the connection circuit is configured to electrically connect an input of the second multiplier to either a second output of the artificial neural network or an output of a delay line

   and/or

   wherein the connection circuit is configured to electrically connect an input to the second multiplier to either a second output of the artificial neural network or an output of a signal partitioning block

   and/or

   wherein the connection circuit is configured to electrically connect the input of the first multiplier to the output of the artificial neural network in a first state and to electrically connect the input of the first multiplier to an output of a delay line in a second state.

4. The Neural Volterra actuator of any preceding Claim, wherein the artificial neural network comprises neurons and programmable connections between the neurons,
   preferably wherein the neurons comprises roaming neurons and/or wherein a neuron of the neurons comprises a look up table and feedback path from a scaled output of the look up table.

5. The Neural Volterra actuator of any preceding Claim, wherein the artificial neural network comprises programmable connections between neurons in different layers of the artificial neural network.

6. The Neural Volterra actuator of any preceding Claim, wherein the first processing block comprises a plurality of non-linear preprocessing blocks having outputs connected to inputs of the artificial neural network.

7. The Neural Volterra actuator of any preceding Claim, further comprising a second connection circuit configured to adjust electrical connections to non-linear preprocessing blocks, and wherein second processing block comprises the non-linear preprocessing blocks, and wherein the non-linear preprocessing blocks have outputs connected to inputs of the non-linear gain blocks.

8. The Neural Volterra actuator of any preceding Claim, wherein the artificial neural network is configured to receive a signal from a sensor.

9. A method of configuring a Neural Volterra actuator for digital predistortion, the method comprising:

electrically connecting an output of an artificial neural network to an input of a multiplier with a connection circuit such that the multiplier is configured to multiply an output signal from the artificial neural network with a signal from a second processing path that includes a non-linear gain block;
wherein the Neural Volterra actuator comprises the artificial neural network, the connection circuit, a plurality of multipliers comprising the multiplier, a plurality of non-linear gain blocks comprising the non-linear gain block, and a combiner configured to generate a combined output signal based on output signals from the plurality of multipliers, and
wherein the combined output signal is a digitally predistorted version of an input signal received by the Neural Volterra actuator.

10. The method of Claim 9, further comprising adjusting an electrical connection to the input of the multiplier with the connection circuit such that an output of a signal partitioning block is provided to the input of the multiplier.

11. The method of Claim 9 or 10, further comprising adjusting connections between neurons of the artificial neural network in different layers of the artificial neural network.

12. The method of any of Claims 9 to 11, wherein the connection circuit provides a fixed connection between a second output of the artificial neural network and an input of a second multiplier of the plurality of multipliers.

13. The method of any of Claims 9 to 12, wherein the second processing path comprises a non-linear preprocessing block having an output connected to an input of the non-linear gain block, and the method further comprises setting a connection to an input of the non-linear preprocessing block with a second connection circuit.

14. A system with digital predistortion, the system comprising:

a transceiver integrated circuit comprising a digital predistortion system, the digital predistortion system comprising a Neural Volterra actuator of any of claims 1 to 8; and
a power amplifier in communication with the transceiver integrated circuit, the digital predistortion system configured to reduce a non-linearity of the power amplifier.

15. The system of Claim 14, further comprising an antenna in communication with the power amplifier and/or further comprising a sensor, the artificial neural network configured to receive a sensor signal from the sensor.

FIG. 1

FIG. 2

EP 4 668 578 A1

300

302 Gather specifications & operating conditions

304 Define a model configuration

306 Optimize model parameters

308 Performance Threshold Satisfied?

No → 310 Optimize AI Compute logic

Yes

312 Optimize Volterra DSP logic

No

314 Specification met?

No

Yes

Exit

**FIG. 3**

FIG. 4

EP 4 668 578 A1

FIG. 5

514

○ Each circle of the Feature NN is a
   Processing Element

Feature NN

Quasi Static controls

Weights   Bias   Scale   Bias   Scale

602   604   606   608   612   614

LUT

Delay

610

600

**FIG. 6**

FIG. 7

FIG. 8

FIG. 9

EP 4 668 578 A1

**Non-Linear Pre-Processing (NL PP)**

1002A — Non-Linear LUT / CORDIC / Real / Imag

1004A — MUX

1006 — Arithmetic Processing Unit

1008 — MUX / Decoder

Non-Linear LUT / CORDIC / Real / Imag

1004B — MUX

*N* inputs

1002N — Non-Linear LUT / CORDIC / Real / Imag

*M (MSB)*

*L (LSB)*

1000

**FIG. 10**

1100

*LSB*

*LUT(MSB+1)*

*LUT(MSB)*

1102 — SUB

1104 — MULT

1106 — SHIFT

1108 — RND/ SAT

1110 — ADD

1112 — SHIFT

1114 — RND/ SAT

**FIG. 11**

FIG. 12

FIG. 13

Europäisches
Patentamt

European
Patent Office

Office européen
des brevets

# EUROPEAN SEARCH REPORT

**Application Number**

EP 25 18 1407

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/368571 A1 (YU TAO [US] ET AL) 17 November 2022 (2022-11-17) | 1,2,4,5, 7-15 | INV. H03F1/32 |
| A | * paragraphs [0004], [0043], [0080], [0089]; figure 2 * | 3,6 | H03F3/195 H03F3/24 |
| | ----- | | H04B1/04 |
| X | YU YUCHENG ET AL: "Self-Sensing Digital Predistortion of RF Power Amplifiers for 6G Intelligent Radio", IEEE MICROWAVE AND WIRELESS COMPONENTS LETTERS, IEEE SERVICE CENTER, NEW YORK, NY, US, vol. 32, no. 5, 11 January 2022 (2022-01-11), pages 475-478, XP011907829, ISSN: 1531-1309, DOI: 10.1109/LMWC.2021.3139018 [retrieved on 2022-01-11] | 1,2,4,5, 7-15 | G06N3/00 |
| A | * I. Introduction; figure 3 * | 3,6 | |
| | ----- | | |

**TECHNICAL FIELDS SEARCHED (IPC)**

H03F
H04B
G06N

The present search report has been drawn up for all claims

| Place of search | Date of completion of the search | Examiner |
|---|---|---|
| The Hague | 22 October 2025 | Goethals, Filip |

## ANNEX TO THE EUROPEAN SEARCH REPORT
## ON EUROPEAN PATENT APPLICATION NO.

EP 25 18 1407

This annex lists the patent family members relating to the patent documents cited in the above-mentioned European search report.
The members are as contained in the European Patent Office EDP file on
The European Patent Office is in no way liable for these particulars which are merely given for the purpose of information.

22-10-2025

| Patent document cited in search report | Publication date | Patent family member(s) | Publication date |
|---|---|---|---|
| US 2022368571 A1 | 17-11-2022 | CN 117546410 A | 09-02-2024 |
| | | EP 4338284 A1 | 20-03-2024 |
| | | JP 2024520936 A | 27-05-2024 |
| | | US 2022368571 A1 | 17-11-2022 |
| | | US 2025047529 A1 | 06-02-2025 |
| | | WO 2022240732 A1 | 17-11-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63661446
- US 74722124
- US 74723024
- US 11558078 B